# EUROPÄISCHE PATENTSCHRIFT

(11) **EP 1 327 267 B1**
(45) Veröffentlichungstag und Bekanntmachung des Hinweises auf die Patenterteilung: **06.12.2017**
(21) Anmeldenummer: 01987950.1
(22) Anmeldetag: 08.10.2001
(51) Int. Cl.: H01L 21/02, H01L 33/00

(54) **VERFAHREN ZUR HERSTELLUNG EINES HALBLEITERBAUELEMENTS AUF GAN-BASIS**
METHOD FOR THE PRODUCTION OF A SEMICONDUCTOR COMPONENT MADE FROM GAN
PROCEDE DE FABRICATION D'UN COMPOSANT SEMI-CONDUCTEUR A BASE DE GAN

(30) Priorität: 17.10.2000 DE 10051465
(43) Veröffentlichungstag der Anmeldung: 16.07.2003
(73) Patentinhaber: OSRAM Opto Semiconductors GmbH, 93055 Regensburg (DE)
(72) Erfinder: BADER, Stefan, 93161 Eilsbrunn (DE); EISERT, Dominik, 93049 Regensburg (DE); HAHN, Berthold, 93155 Hernau (DE); HÄRLE, Volker, 93164 Waldetzenberg (DE)
(74) Vertreter: Epping - Hermann - Fischer
(86) Internationale Anmeldenummer: PCT/DE2001/003851
(87) Internationale Veröffentlichungsnummer: WO 2002/033760

(56) Entgegenhaltungen:
- EP-A- 0 282 075
- EP-A- 0 317 445
- EP-A- 0 404 565
- EP-A- 0 740 376
- EP-A- 0 810 674
- EP-A- 0 871 228
- EP-A- 0 905 797
- WO-A-00/19499
- DE-A- 19 741 442
- DE-A- 19 830 838
- US-A- 5 157 468
- US-A- 5 661 074
- US-A- 5 780 873
- US-A- 5 786 606
- US-A- 5 862 167
- PATENT ABSTRACTS OF JAPAN vol. 1998, no. 13, 30. November 1998 (1998-11-30) -& JP 10 223496 A (ION KOGAKU KENKYUSHO), 21. August 1998 (1998-08-21)
- PATENT ABSTRACTS OF JAPAN vol. 1999, no. 08, 30. Juni 1999 (1999-06-30) & JP 11 068157 A (SUMITOMO ELECTRIC IND), 9. März 1999 (1999-03-09)

## Beschreibung

Die Erfindung bezieht sich auf ein Verfahren zur Herstellung eines Halbleiterbauelements auf GaN-Basis nach dem Oberbegriff des Patentanspruchs 1.
Halbleiterbauelemente auf GaN-Basis dienen vorwiegend der Strahlungserzeugung im blau-grünen Spektralbereich und weisen eine Mehrzahl von Schichten auf, die aus einem GaN-basierenden Material bestehen. Solche Materialien sind neben GaN selbst von GaN abgeleitete oder mit GaN verwandte Materialien sowie darauf aufbauende ternäre oder quaternäre Mischkristalle. Insbesondere fallen hierunter die Materialien AlN, InN, AlGaN (Al₁₋ₓGaₓN, 0≤x≤1), InGaN (In₁₋ₓGaₓN, 0≤x≤1), InAlN (In₁₋ₓAlₓN, 0≤x≤1) und AlInGaN (Al_{1-x-y}InₓGa_{y}N, 0≤x≤1, 0≤y≤1). Die Bezeichnung "GaN-basierend" bezieht sich im folgenden neben GaN selbst auf diese Materialsysteme.
Zur Herstellung von GaN-basierenden Halbleiterbauelementen werden üblicherweise Epitaxieverfahren herangezogen. Die Auswahl des Epitaxiesubstrats ist dabei sowohl für den Herstellungsprozeß als auch die Funktion des Bauelements von entscheidender Bedeutung.
Häufig werden hierfür Saphir- oder SiC-Substrate verwendet, die jedoch beide gewisse Nachteile mit sich bringen. So ist beispielsweise die Gitterfehlanpassung bei Saphir bezüglich GaN-basierenden Schichten vergleichsweise groß.
SiC-Substrate weisen diesbezüglich eine bessere Gitteranpassung an GaN-basierende Materialien auf. Allerdings ist die Herstellung von SiC-Substraten mit ausreichender Kristallqualität mit sehr hohen Kosten verbunden. Zudem ist die Ausbeute an GaN-basierenden Halbleiterbauelementen vergleichsweise gering, da die Größe von SiC-Wafern auf Durchmesser begrenzt ist, die typischerweise deutlich unter 150 mm liegen.
Aus der Patentschrift US 5,786,606 ist ein Herstellungsverfahren für strahlungsemittierende Halbleiterbauelemente auf GaN-Basis bekannt, bei dem auf einem SIMOX-Substrat (Separation by IMplantation of OXygen) oder einem SOI-Substrat (Silicon On Isolator) zunächst eine SiC-Schicht epitaktisch aufgewachsen wird. Auf dieser SiC-Schicht wird danach eine Mehrzahl von GaN-basierenden Schichten abgeschieden.
Durch die SiC-Schicht wird jedoch die Strahlungsausbeute des Bauelements reduziert, da in der SiC-Schicht ein Teil der erzeugten Strahlung absorbiert wird. Weiterhin erfordert auch die epitaktische Ausbildung einer SiC-Schicht mit ausreichender Kristallqualität einen hohen Herstellungsaufwand.

JP H10-223496 offenbart ein Verfahren zum Herstellen eines Halbleiterbauelements wobei eine SiC Zwischenschicht mittels eines Bonding-Verfahrens auf einen SiC Stubstratkörper aufgebracht wird und eine weitere SiC Schicht epitaktisch auf die SiC Zwischenschicht aufgebracht wird.

Der Erfindung liegt die Aufgabe zugrunde, ein technisch einfaches und kostengünstiges Herstellungsverfahren für GaN-basierende Halbleiterbauelemente anzugeben. Weiterhin ist es Aufgabe der Erfindung, ein Herstellungsverfahren für Halbleiterbauelemente mit einer erhöhten Strahlungsausbeute zu entwickeln.
Diese Aufgabe wird durch ein Herstellungsverfahren nach Patentanspruch 1 gelöst. Vorteilhafte Weiterbildungen der Erfindung sind Gegenstand der abhängigen Ansprüche.
Bei dem erfindungsgemäßen Herstellungsverfahren wird eine Mehrzahl von GaN-basierenden Schichten epitaktisch auf ein Verbundsubstrat aufgebracht, das einen Substratkörper und eine Zwischenschicht aufweist, wobei der thermische Ausdehnungskoeffizient des Substratkörpers ähnlich oder größer ist als der thermische Ausdehnungskoeffizient der GaN-basierenden Schichten.

Bei einer Mehrzahl GaN-basierender Schichten unterschiedlicher Zusammensetzung unterscheiden sich auch deren thermische Ausdehnungskoeffizienten. Diese Abweichungen sind aber in der Regel geringfügig und können gegenüber dem Unterschied zum thermischen Ausdehnungskoeffizienten des Substratkörpers vernachlässigt werden. Als thermischer Ausdehnungskoeffizient der GaN-basierenden Schichten ist dabei vor allem der thermische Ausdehungskoeffizient der an das Verbundsubstrat angrenzenden Schicht maßgeblich. Weiterhin kann hierfür je nach Struktur der Schichtenfolge auch der thermische Ausdehnungskoeffizient der GaN-basierenden Schicht mit der größten Dicke oder der Mittelwert der thermischen Ausdehnungskoeffizienten, gegebenfalls gewichtet mit der jeweiligen Schichtdicke, herangezogen werden.
Bei der Erfindung ist der thermische Ausdehnungskoeffizient des Substratkörpers größer oder ähnlich diesem thermischen Ausdehnungskoeffizienten der GaN-basierenden Schichten. Im letzeren Fall weicht vorzugsweise der thermische Ausdehungskoeffizient des Substratkörpers um nicht mehr als 50%, besonders bevorzugt nicht mehr als 30% von dem Ausdehnungskoeffizienten der GaN-basierenden Schichten ab.
Unter einem Verbundsubstrat ist ein Substrat zu verstehen, das mindestens zwei Bereiche, den Substratkörper und die Zwischenschicht, enthält und als solches das Ausgangssubstrat für das Epitaxieverfahren darstellt. Die Zwischenschicht ist nicht epitaktisch, sondern vermittels eines Bonding-Verfahrens auf den Substratkörper aufgebracht.
Als Bonding-Verfahren eignet sich bevorzugt ein oxidisches Bonding-Verfahren oder ein Waferbonding-Verfahren. Beim oxidischen Bonding werden Substratkörper und Zwischenschicht unter Ausbildung einer Oxidschicht, beispielweise einer Siliziumoxidschicht, als Haftschicht miteinander verbunden, während beim Waferbonden der Substratkörper und die Zwischenschicht unmittelbar aneinandergefügt werden. Weitergehend können auch andere Bonding-Verfahren, beispielsweise eutektische Bonding-Verfahren oder Bonding-Verfahren, bei denen eine nichtoxidische Haftschicht ausgebildet wird, verwendet werden.

Bei einem Verbundsubstrat der beschriebenen Art sind die thermischen Eigenschaften vor allem durch den Substratkörper bestimmt, während davon weitgehend unabhängig die Epitaxieoberfläche und insbesondere deren Gitterkonstante durch die Zwischenschicht festgelegt ist. Somit kann mit Vorteil die Zwischenschicht optimal an die Gitterkonstante der aufzubringenden Schichten angepaßt werden. Zugleich wird durch die Verwendung eines Substratkörpers mit einem ausreichend hohen thermischen Ausdehnungskoeffizienten verhindert, daß nach der Aufbringung der GaN-basierenden Schichten diese in der Abkühlphase zugverspannt werden und sich dadurch Risse in den Schichten bilden. Vorzugsweise wird daher die Zwischenschicht so dünn ausgebildet, daß der thermische Ausdehnungskoeffizient des gesamten Verbundsubstrats im wesentlichen dem Ausdehnungskoeffizienten des Substratkörpers entspricht. Typischerweise ist dabei der Substratkörper mindestens zwanzigmal dikker als die Zwischenschicht.

Bei einer vorteilhaften Ausgestaltung der Erfindung enthält der Substratkörper SiC, Si oder GaN, vorzugsweise polykristallin (Poly-SiC, Poly-Si bzw. Poly-GaN), Saphir oder AlN. Der thermische Ausdehnungskoeffizient von SiC ist ähnlich dem Ausdehnungskoeffizienten von GaN-basierenden Materialien, die übrigen genannten Materialien weisen einen größeren thermischen Ausdehnungskoeffizienten als GaN-basierende Materialien auf. Damit wird mit Vorteil eine Rissbildung bei der Abkühlung der epitaktisch aufgebrachten Schichten vermieden.

Bei einer bevorzugten Ausgestaltung der Erfindung enthält die Zwischenschicht SiC, Silizium, Saphir, MgO, GaN oder AlGaN. Diese Materialien eignen sich insbesondere zur Ausbildung einer im wesentlichen monokristallinen Oberfläche mit einer an GaN angepaßten Gitterkonstante. Bevorzugt wird als Epitaxieoberfläche eine Si(111)-Oberfläche oder eine monokristalline SiC-Oberfläche verwendet, auf der die GaN-basierenden Schichten aufgewachsen werden.

Bei der Erfindung werden die GaN-basierenden Schichten auf einem Verbundsubstrat abgeschieden, bei dem die Zwischenschicht durch ein Bonding-verfahren, beispielsweise ein Waferbonding-Verfahren oder ein oxidisches Bondingverfahren, auf den Substratkörper aufgebracht ist. Vorzugsweise wird zwischen Substratkörper und Zwischenschicht eine Haftschicht, beispielsweise aus Siliziumoxid, ausgebildet.
Mittels eines Bonding-Verfahrens kann mit Vorteil eine Vielzahl von Materialsystemen kombiniert werden, ohne durch Materialunverträglichkeiten, wie sie beispielsweise beim epitaktischen Aufbringen einer Zwischenschicht auf einen Substratkörper auftreten, limitiert zu sein.
Um eine ausreichend dünne Zwischenschicht zu erhalten, kann dabei auch zunächst eine dickere Zwischenschicht auf den Substratkörper aufgebondet werden, die dann, beispielsweise durch Schleifen oder Spalten, auf die erforderliche Dicke abgedünnt wird.
Bei einer vorteilhaften Weiterbildung der Erfindung wird vor der Abscheidung der GaN-basierenden Schichten auf dem Verbundsubstrat eine Maskenschicht ausgebildet, so daß nur auf den von der Maske unbedeckten Bereichen der Epitaxieoberfläche die GaN-basierenden Schichten aufwachsen. Dadurch werden mit Vorteil die GaN-basierenden Schichten in der Schichtebene unterbrochen und so ein zusätzlicher Schutz gegen Zugverspannung und die damit einhergehende Rissbildung erreicht.
Eine weiter bevorzugte Ausgestaltung der Erfindung besteht darin, die GaN-basierenden Schichten nach der Abscheidung auf dem Verbundsubstrat in einzelne Halbleiterschichtstapel zu strukturieren. Danach wird auf die GaN-basierenden Halbleiterschichtstapel ein Träger aufgebracht und das Verbundsubstrat abgelöst. Das Verbundsubstrat kann so zumindest zu Teilen wiederverwendet werden. Dies stellt einen besonderen Vorteil bei SiC-Substratkörpern dar, deren Herstellung mit sehr hohen Kosten verbunden ist. Weiterhin wird auf diese Art und Weise ein Dünnschichtbauelement hergestellt. Unter einem Dünnschichtbauelement ist dabei ein Bauelement zu verstehen, das kein Epitaxiesubstrat enthält.

Im Falle von strahlungsemittierenden Halbleiterbauelementen wird so eine Erhöhung der Strahlungsausbeute erzielt, da eine Absorption der erzeugten Strahlung im Epitaxiesubstrat, wie sie insbesondere bei SiC-Substraten auftritt, vermieden wird.

Als Material für den Träger eignen sich beispielsweise GaAs, Germanium, Silizium, Zinkoxid oder Metalle, insbesondere Molybdän, Aluminium, Kupfer, Wolfram, Eisen, Nickel, Kobalt oder Legierungen hiervon.

Bevorzugt ist dabei das Trägermaterial so gewählt, daß dessen thermischer Ausdehnungskoeffizient an den thermischen Ausdehnungskoeffizienten der GaN-basierenden Schichten und gegebenenfalls an den thermischen Ausdehnungskoeffizienten des Substratkörpers angepaßt ist. Eine Anpassung an den thermischen Ausdehnungskoeffizienten des Substratkörpers ist insbesondere dann zweckmäßig, wenn zwischen Aufbringung des Trägers und Ablösung der GaN-basierenden Schichten von dem Verbundsubstrat die Temperatur geändert wird. Stark unterschiedliche thermische Ausdehnungskoeffizienten würden zu einer unterschiedlichen Ausdehnung von Träger und Verbundsubstrat führen und so die Gefahr einer Beschädigung der dazwischenliegenden GaN-basierenden Schichten aufgrund zu hoher mechanischer Spannungen erhöhen.

Eine Anpassung der thermischen Ausdehnungskoeffizienten von Träger und GaN-basierenden Schichten ist vorteilhaft, um mechanische Spannungen, die einerseits nach der Herstellung der Halbleiterkörper während einer Abkühlphase und andererseits im Betrieb, beispielweise aufgrund einer Aufheizung durch Verlustleistung, auftreten können, gering zu halten.

Angepaßte thermische Ausdehnungskoeffizienten sind insbesondere dadurch gekennzeichnet, daß ihre Differenz so gering ist, daß im Rahmen der auftretenden Temperaturänderungen im wesentlichen keine Schäden an den GaN -basierenden Schichten durch thermisch induzierte mechanische Verspannungen verursacht werden. Vorzugsweise sollte die relative Abweichung des thermischen Ausdehnungskoeffizienten des Trägers von dem thermischen Ausdehnungskoeffizienten des Verbundsubstrats kleiner als 50%, besonders bevorzugt kleiner als 30% sein.

Die auftretenden Temperaturänderungen sind beispielsweise bedingt durch das jeweilige Verfahren zur Trennung der GaN-basierenden Schichten von dem Verbundsubstrat, die bei der Herstellung, insbesondere während der Aufbringung des Trägers, herrschende Temperatur gegenüber der vorgesehenen Betriebstemperatur und/oder die aufgrund der Betriebspezifikation zu erwartende Verlustleistung.

Bevorzugt ist das Trägermaterial so gewählt, daß der thermische Ausdehungskoeffizient des Trägers zwischen dem thermischen Ausdehnungskoeffizienten des Substratkörpers und dem thermischen Ausdehnungskoeffizienten der GaN-basierenden Schichten liegt. Besonders bevorzugt ist dabei der thermische Ausdehnungskoeffizient des Trägers größer als der arithmetische Mittelwert der thermischen Ausdehungskoeffizienten von Verbundsubstrat und GaN-basierenden Schichten.

Das beschriebene sogenannte Umbonden der Halbleiterschichtstapel von dem Verbundsubstrat auf einen Träger kann bei der Erfindung auch in zwei Schritten erfolgen, wobei die GaN-basierenden Halbleiterschichtstapel zunächst auf einen Zwischenträger und dann auf den eigentlichen Träger gebondet werden, so daß abschließend der eigentliche Träger an die Stelle des Verbundsubstrats tritt. Mit Vorteil weisen so hergestellte Halbleiterschichtstapel eine entsprechende Schichtenfolge wie GaN-basierendes Halbleiterkörper mit Epitaxiesubstrat nach dem Stand der Technik auf, so daß für beide Schichtstapel dieselben nachfolgenden Verarbeitungsschritte wie beispielsweise Vereinzeln, Kontaktieren und Einbau in ein Gehäuse herangezogen werden können.

Bei einer besonders bevorzugten Weiterbildung des Herstellungsverfahrens für strahlungsemittierende Halbleiterkörper auf GaN-Basis wird auf dem Halbleiterschichtstapel zur Steigerung der Strahlungsausbeute eine Reflektorschicht ausgebildet. Die Strahlungsausbeute bei GaN-basierenden Halbleiterbauelementen wird aufgrund des hohen Brechungsindex von GaN-basierenden Materialien zum Großteil durch Reflexion an den Grenzflächen des Halbleiterkörpers begrenzt. Bei strahlungsemittierenden Halbleiterkörpern ohne absorbierendes Substrat können mit Vorteil durch eine Reflektorschicht die an der Auskoppelfläche reflektierten Strahlungsanteile wiederum auf die Auskoppelfläche zurückgerichtet werden. Damit wird die Strahlungsausbeute weiter erhöht.

Vorzugsweise wird die Reflektorschicht als Metallschicht, die beispielsweise Aluminium, Silber oder eine entsprechende Aluminium- oder Silberlegierung enthält, ausgebildet.

Mit Vorteil kann eine solche Metallschicht zugleich als Kontaktfläche verwendet werden. Alternativ kann die Reflektorschicht auch durch eine dielektrische Verspiegelung in Form einer Mehrzahl von dielektrischen Schichten ausgebildet werden.

Bei einer vorteilhaften Weiterbildung der Erfindung wird zumindest ein Teil der Oberfläche des Halbleiterschichtstapels aufgerauht. Dadurch wird eine Totalreflexion an der Oberfläche gestört und so eine Erhöhung der Strahlungsausbeute erzielt. Vorzugsweise erfolgt die Aufrauhung durch Ätzen oder ein Sandstrahlverfahren.

Weitere Merkmale, Vorteile und Zweckmäßigkeiten der Erfindung ergeben sich aus der nachfolgenden Beschreibung von drei Ausführungsbeispielen in Verbindung mit den Figuren 1 bis 3.

Es zeigen
- Figur 1: eine schematische Schnittdarstellung eines ersten Ausführungsbeispiels eines erfindungsgemäßen Herstellungsverfahrens,
- Figur 2: eine schematische Schnittdarstellung eines zweiten Ausführungsbeispiels eines erfindungsgemäßen Herstellungsverfahrens und
- Figur 3: eine schematische Schnittdarstellung eines dritten Ausführungsbeispiels eines erfindungsgemäßen Herstellungsverfahrens.

Gleiche oder gleich wirkende Elemente sind hierbei mit denselben Bezugszeichen versehen.

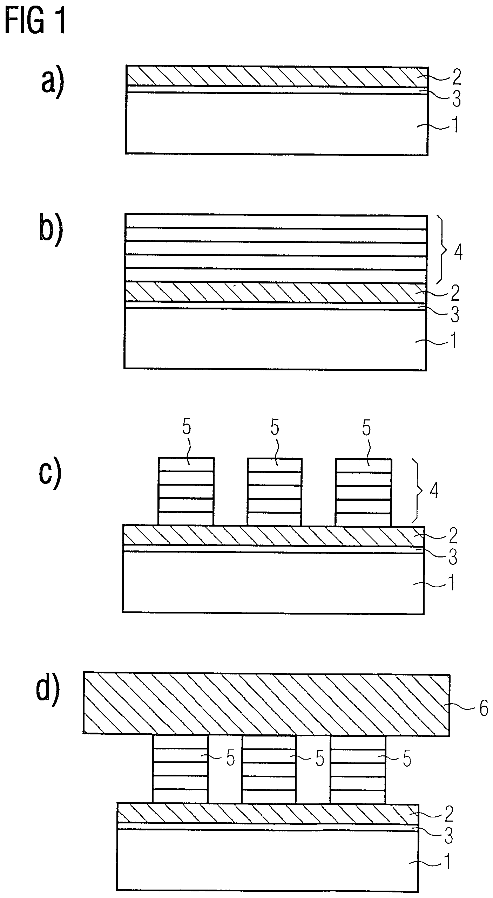

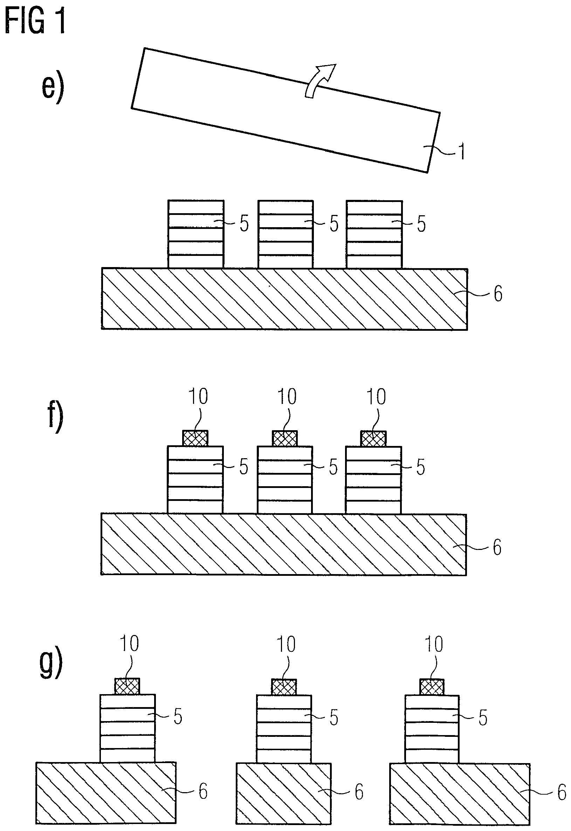

Bei dem in Figur 1 dargestellten Herstellungsverfahren wird ein Verbundsubstrat mit einem Substratkörper 1 aus Poly-SiC verwendet, auf den in bekannter Weise eine monokristalline SiC-Zwischenschicht 2 aufgebondet ist. Hierzu ist zwischen dem Substratkörper 1 und der Zwischenschicht 2 eine Haftschicht 3, beispielsweise aus Siliziumoxid, ausgebildet, Figur 1a.

Auf dieses Verbundsubstrat wird epitaktisch eine Mehrzahl von GaN-basierenden Schichten 4 aufgewachsen, Figur 1b. Die Struktur der Schichtenfolge ist keinen prinzipiellen Beschränkungen unterworfen.

Vorzugsweise wird hierbei eine aktive, der Strahlungserzeugung dienende Schicht ausgebildet, die von einer oder mehreren Mantelschichten und/oder Wellenleiterschichten umgeben ist. Die aktive Schicht kann dabei durch eine Mehrzahl von dünnen Einzelschichten in Form einer Einfach- oder Mehrfachquantentopfstruktur ausgebildet sein.

Weiterhin ist es vorteilhaft, auf der Zwischenschicht 2 zunächst eine Pufferschicht, beispielsweise auf AlGaN-Basis, auszubilden, durch die eine verbesserte Gitteranpassung und eine höhere Benetzbarkeit hinsichtlich der folgenden Schichten erreicht werden kann. Um die elektrische Leitfähigkeit einer solchen Pufferschicht zu erhöhen, können in die Pufferschicht elektrisch leitfähige Kanäle, beispielsweise auf InGaN-Basis, eingeschlossen werden.

Anschließend werden die GaN-basierenden Schichten 4 durch eine laterale Strukturierung, vorzugsweise durch eine Mesa-Ätzung, in einzelne Halbleiterschichtstapel 5 unterteilt, Figur 1c.

Auf diese Halbleiterschichtstapel 5 wird im nächsten Schritt, Figur ld, ein Träger 6, beispielsweise aus GaAs oder einem für die erzeugte Strahlung durchlässigen Material, aufgebracht.

Daraufhin wird das Verbundsubstrat einschließlich der Zwischenschicht 2 von den Halbleiterschichtstapeln 5 abgelöst, Figur 1e. Dies kann beispielsweise durch ein Ätzverfahren erfolgen, bei dem die Zwischenschicht 2 oder die Haftschicht 3 zerstört wird. Weitergehend kann das Verbundsubstrat auch vermittels eines Laserablationsverfahrens entfernt werden, wobei in diesem Fall zweckmäßigerweise ein für die verwendete Laserstrahlung durchlässiger Substratkörper, beispielsweise ein Saphirsubstratkörper, verwendet wird. Die Laserstrahlung kann so durch den Substratkörper hindurch auf die Zwischenschicht beziehungsweise die Haftschicht eingestrahlt werden. Mit Vorteil kann der Substratkörper 1 in einem weiteren Herstellungszyklus wiederverwendet werden.

Wird zwischen der Aufbringung des Trägers und der Ablösung des Verbundsubstrats die Temperatur geändert, so ist eine Anpassung der thermischen Ausdehnungskoeffizienten von Träger und Substratkörper besonders zweckmäßig. Beispielsweise eignet sich in Verbindung mit einem Saphirsubstratkörper ein GaAs, Molybdän, Wolfram oder eine Fe-Ni-Co-Legierung enthaltender Träger. Zur Aufbringung eines metallischen Trägers kann beispielsweise ein eutektisches Bonding-Verfahren angewandt werden.

In Verbindung mit einem SiC-Substratkörper ist ein Silizium oder SiC, jeweils monokristallin oder vorzugsweise polykristallin, enthaltendes Material als Trägermaterial vorteilhaft. Hierbei eignet sich beispielsweise ein oxidisches Bonding-Verfahren zur Aufbringung des Trägers.

Nachfolgend werden auf die so gebildeten Dünnschichthalbleiterkörper 5 Kontaktflächen 10 aufgebracht, Figur 1f. Abschließend werden die Halbleiterschichtstapel 5 vereinzelt, Figur 1g, und in üblicher Weise weiterverarbeitet.

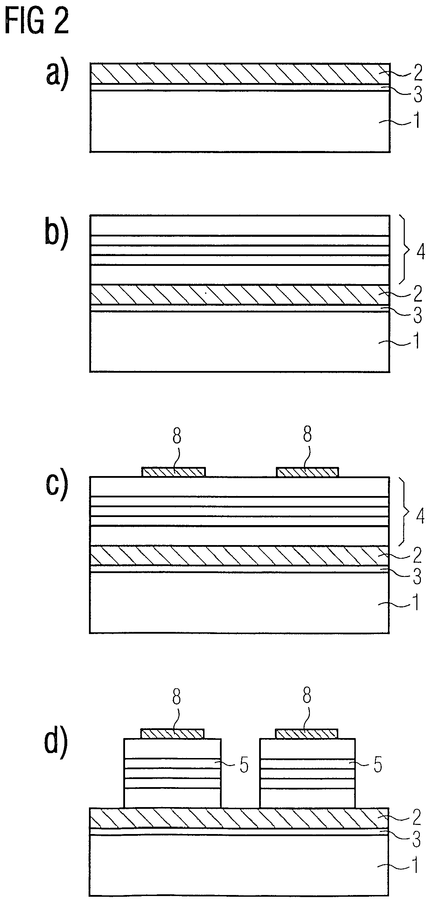

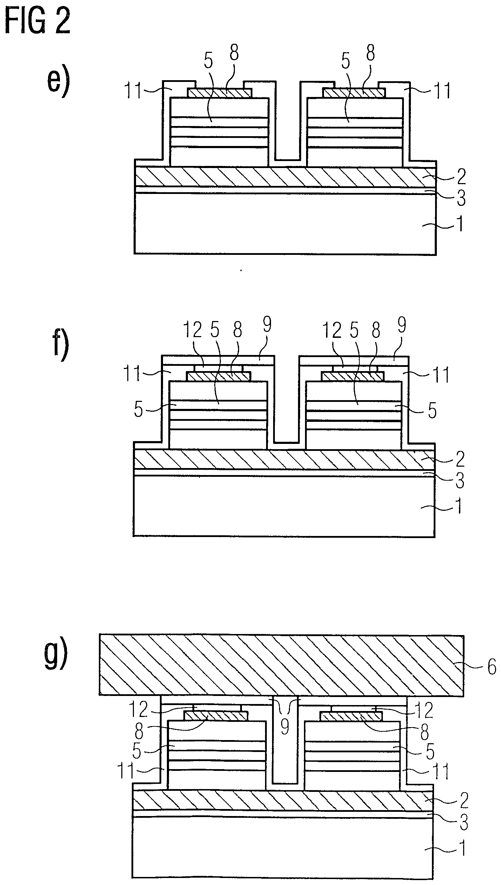

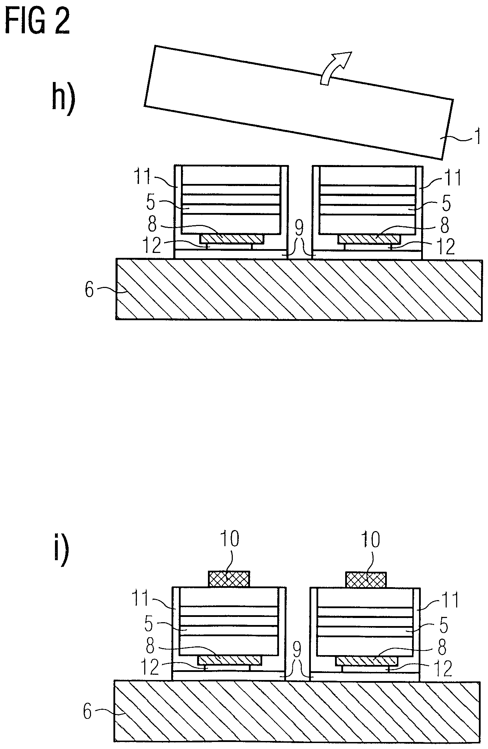

Bei dem in Figur 2 dargestellten Herstellungsverfahren wird wiederum ein Verbundsubstrat verwendet, das im wesentlichen von einem Poly-SiC-Substratkörper 1 und einer Si(111)-Zwischenschicht 2 gebildet wird. Die Zwischenschicht 2 ist mit Hilfe eines oxidischen Bonding-Verfahrens auf den Substratkörper 1 unter Ausbildung einer Siliziumoxid-Haftschicht 3 aufgebracht, Figur 2a. Alternativ können Substratkörper 1 und Zwischenschicht 2 auch durch ein anderes Bonding-Verfahren, zum Beispiel Waferbonding, verbunden werden.

Auf dieses Verbundsubstrat wird wiederum eine Mehrzahl von GaN-basierenden Schichten aufgewachsen, Figur 2b, die abschließend mit einer Kontaktschicht 8, beispielsweise aus Platin, versehen wird, Figur 2c.

Nachfolgend werden die GaN-basierenden Schichten 4 durch eine Ätzstrukturierung in einzelne Halbleiterschichtstapel 5 unterteilt, Figur 2d.

Auf diese so gebildeten Halbleiterschichtstapel 5 wird zum Schutz eine Passivierungsschicht 11, vorzugsweise auf Siliziumnitrid-Basis, aufgebracht, Figur 2e.

Auf den nicht von der Passivierungsschicht bedeckten Bereichen der Kontaktschicht 8 wird nun jeweils ein Bondlot 12 und darauf ein Reflektor 9 aus einer Silber- oder Aluminiumlegierung abgeschieden, Figur 2f.

Anschließend werden die Halbleiterschichtstapel 5 mit dem Reflektor 9 vermittels eines eutektischen Bonding-Verfahrens auf einen Träger 6 umgebondet, Figur 2g.

Im nächsten Schritt, Figur 2h, wird der Substratkörper 1 entfernt und kann so wiederverwendet werden.

Abschließend werden die einzelnen Halbleiterschichtstapel oberseitig mit Kontaktflächen 10 versehen, Figur 2i. Nachfolgend können die Halbleiterschichtstapel vereinzelt und gegebenenfalls in ein Gehäuse eingebaut werden (nicht dargestellt).

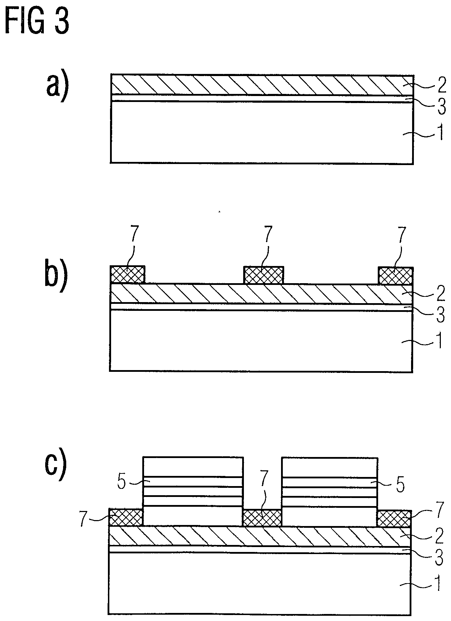

Das in Figur 3 dargestellt Ausführungsbeispiel eines erfindungsgemäßen Herstellungsverfahrens stellt eine Variante der vorigen Ausführungsbeispiele dar.

Wiederum wird, wie bereits beschrieben, als Epitaxiesubstrat ein Verbundsubstrat verwendet, Figur 3a.

Vor der Abscheidung der GaN-basierenden Schichten 4 wird auf die Epitaxieoberfläche der Zwischenschicht 2 eine Maskenschicht 7 aufgebracht, Figur 3b. Die GaN-basierenden Schichten 4 wachsen so nur auf den Bereichen der Epitaxieoberfläche auf, die von der Maskenschicht 7 nicht bedeckt sind (Epitaxiefenster), Figur 3c. Dadurch werden die GaN-basierenden Schichten 4 in Richtung der Schichtebene unterbrochen. So wird zusätzlich eine Zugverspannung in den eptiaktisch abgeschiedenen Schichten in der Abkühlphase vermieden.
Nachfolgend kann das Herstellungsverfahren wie in den anderen Ausführungsbeipielen fortgesetzt werden.
Die Erläuterung der Erfindung anhand der beschriebenen Ausführungsbeispiele ist selbstverständlich nicht als Beschränkung der Erfindung hierauf zu verstehen, sondern umfaßt alle Ausführungsformen, gemäß der Ansprüche.

## Patentansprüche

1. Verfahren zum epitaktischen Herstellen eines Halbleiterbauelements mit einer Mehrzahl von GaN-basierenden Schichten (4),
wobei
die GaN-basierenden Schichten (4) auf ein Verbundsubstrat aufgebracht werden, das einen Substratkörper (1) und eine Zwischenschicht (2) aufweist, wobei der thermische Ausdehnungskoeffizient des Substratkörpers (1) um nicht mehr als 50% von dem thermischen Ausdehnungskoeffizienten der GaN-basierenden Schichten (4) abweicht oder größer ist als der thermische Ausdehnungskoeffizient der GaN-basierenden Schichten (4), wobei die GaN-basierenden Schichten (4) epitaktisch auf der Zwischenschicht (2) abgeschieden werden, und wobei der Substratkörper (1) mindestens zwanzigmal dicker als die Zwischenschicht (2) ist,
dadurch gekennzeichent, dass
die Zwischenschicht (2) mittels eines Bonding-Verfahrens auf den Substratkörper (1) aufgebracht wird.

2. Verfahren nach Anspruch 1,
wobei
der Substratkörper (1) SiC, Poly-SiC, Si, Poly-Si, Saphir, GaN, Poly-GaN oder A1N enthält.

3. Verfahren nach einem der Ansprüche 1 oder 2,
wobei
die Zwischenschicht (2) SiC, Si, Saphir, MgO, GaN oder AlGaN enthält.

4. Verfahren nach einem der Ansprüche 1 bis 3,
wobei
die Zwischenschicht (2) zumindest in Teilbereichen eine monokristalline Oberfläche aufweist.

5. Verfahren nach einem der Ansprüche 1 bis 4,
wobei
der Substratkörper (1) Poly-SiC und die Zwischenschicht (2) monokristallines SiC enthält.

6. Verfahren nach einem der Ansprüche 1 bis 4,
wobei
der Substratkörper (1) Poly-Si und die Zwischenschicht (2) monokristallines Si enthält.

7. Verfahren nach einem der Ansprüche 1 bis 4,
wobei
der Substratkörper (1) Poly-GaN und die Zwischenschicht (2) monokristallines GaN enthält.

8. Verfahren nach einem der Ansprüche 1 bis 7,
wobei
die GaN-basierenden Schichten (4) auf einer Si(111)-Oberfläche oder einer zumindest in Teilbereichen monokristallinen SiC-Oberfläche der Zwischenschicht (2) abgeschieden werden.

9. Verfahren nach einem der Ansprüche 1 bis 8,
wobei
die Zwischenschicht (2) vermittels eines oxidischen Bonding-Verfahrens oder eines Waferbonding-Verfahrens, auf den Substratkörper (1) aufgebracht ist.

10. Verfahren nach einem der Ansprüche 1 bis 9,
wobei
zwischen Substratkörper (1) und Zwischenschicht (2) eine Haftschicht (3) ausgebildet ist.

11. Verfahren nach Anspruch 10,
wobei
die Haftschicht (3) Siliziumoxid enthält.

12. Verfahren nach einem der Ansprüche 1 bis 11,
wobei
vor dem Aufbringen der GaN-basierenden Schichten (4) auf dem Verbundsubstrat eine Maskenschicht (7) mit Epitaxiefenstern ausgebildet wird, wobei die Epitaxieoberfläche des Verbundsubstrats innerhalb der Epitaxiefenster unbedeckt bleibt.

13. Verfahren nach einem der Ansprüche 1 bis 12,
wobei
die GaN-basierenden Schichten (4) nach der Aufbringung auf das Verbundsubstrat in einzelne Halbleiterschichtstapel (5) strukturiert werden.

14. Verfahren nach Anspruch 13,
wobei
das Verfahren fortgesetzt wird mit den Schritten:
- Aufbringen eines Trägers (6) auf die Halbleiterschichtstapel (5),
- Ablösen des Verbundsubstrats.

15. Verfahren nach Anspruch 13,
wobei
das Verfahren fortgesetzt wird mit den Schritten:
- Aufbringen eines Zwischenträgers auf die Halbleiterschichtstapel (5),
- Ablösen des Verbundsubstrats,
- Aufbringen eines Trägers (6) auf der Seite der Halbleiterschichtstapel (5), von der das Verbundsubstrat abgelöst wurde,
- Ablösen des Zwischenträgers.

16. Verfahren nach Anspruch 14 oder 15,
wobei
der Träger (6) mindestens eine der Verbindungen beziehungsweise mindestens eines der Elemente GaAs, Germanium, Silizium, Zinkoxid, Molybdän, Aluminium, Kupfer, Eisen, Nickel oder Kobalt enthält.

17. Verfahren nach Anspruch 16,
wobei
der Substratkörper Saphir und der Träger (6) GaAs, Molybdän, Wolfram oder eine Fe-Ni-Co-Legierung enthält.

18. Verfahren nach Anspruch 16,
wobei
der Substratkörper (1) SiC und der Träger (6) Silizium oder SiC enthält.

19. Verfahren nach einem der Ansprüche 14 bis 18,
wobei
der thermische Ausdehnungskoeffizient des Trägers (6) zwischen dem thermischen Ausdehnungskoeffizienten des Substratkörpers (1) und dem thermischen Ausdehnungskoeffizienten der GaN-basierenden Schichten (4) liegt.

20. Verfahren nach einem der Ansprüche 1 bis 19
wobei
auf den GaN-basierenden Schichten (4) beziehungsweise den Halbleiterschichtstapeln (5) eine Reflektorschicht (9) ausgebildet wird.

21. Verfahren nach Anspruch 20,
wobei
die Reflektorschicht (9) durch Aufbringen einer Metallschicht gebildet wird.

22. Verfahren nach Anspruch 21,
wobei
die Metallschicht Silber, Aluminium oder eine Silber- oder Aluminiumlegierung enthält.

23. Verfahren nach einem der Ansprüche 20 bis 22,
wobei
die Reflektorschicht (9) zugleich als Kontaktfläche dient.

24. Verfahren nach Anspruch 20,
wobei
die Reflektorschicht (9) durch eine dielektrische Verspiegelung gebildet wird.

25. Verfahren nach einem der Ansprüche 13 bis 24,
wobei
die Oberfläche der Halbleiterschichtstapel (5) zumindest bereichsweise aufgerauht wird.

26. Verfahren nach Anspruch 25,
wobei
die Oberfläche der Halbleiterschichtstapel (5) durch Ätzen aufgerauht wird.

27. Verfahren nach Anspruch 25 oder 26,
wobei
die Oberfläche der Halbleiterschichtstapel (5) durch ein Sandstrahlverfahren aufgerauht wird.

## Claims

1. Method for epitaxial fabrication of a semiconductor component with a plurality of GaN-based layers (4),
wherein
the GaN-based layers (4) are applied on to a composite substrate, which comprises a substrate body (1) and an interlayer (2), wherein the thermal expansion coefficient of the substrate body (1) deviates from the thermal expansion coefficient of the GaN-based layers (4) by no more than 50 % or is greater than the thermal expansion coefficient of the GaN-based layers (4), wherein the GaN-based layers (4) are epitaxially deposited on the interlayer (2), and wherein the substrate body (1) is at least 20 times thicker than the interlayer (2),
**characterized in that**
the interlayer (2) is applied on to the substrate body (1) by means of a bonding process.

2. The method according to claim 1,
wherein
the substrate body (1) contains SiC, Poly-SiC, Si, Poly-Si, sapphire, GaN, Poly-GaN or AlN.

3. The method according to one of claims 1 or 2,
wherein
the interlayer (2) contains SiC, Si, sapphire, MgO, GaN or AlGaN.

4. The method according to one of claims 1 to 3,
wherein
the interlayer (2) comprises a monocrystalline surface at least in sub-regions.

5. The method according to one of claims 1 to 4,
wherein
the substrate body (1) contains Poly-SiC and the interlayer (2) contains monocrystalline SiC.

6. The method according to one of claims 1 to 4,
wherein
the substrate body (1) contains Poly-Si and the interlayer (2) contains monocrystalline Si.

7. The method according to one of claims 1 to 4,
wherein
the substrate body (1) contains Poly-GaN and the interlayer (2) contains monocrystalline GaN.

8. The method according to one of claims 1 to 7,
wherein
the GaN-based layers (4) are deposited on a Si(111)-surface or an SiC surface of the interlayer (2) which is monocrystalline at least in sub-regions.

9. The method according to one of claims 1 to 8,
wherein
the interlayer (2) is applied on to the substrate body (1) by means of an oxidic bonding process or a wafer bonding process.

10. The method according to one of claims 1 to 9,
wherein
an adhesive layer (3) is formed between the substrate body (1) and the interlayer (2).

11. The method according to claim 10,
wherein
the adhesive layer (3) contains silicon oxide.

12. The method according to one of claims 1 to 11,
wherein
prior to the application of the GaN-based layers (4) on to the composite substrate, a mask layer (7) having epitaxy windows is formed on the composite substrate, wherein the epitaxy surface of the composite substrate remains uncovered within the epitaxy windows.

13. The method according to one of claims 1 to 12,
wherein
after application on to the composite substrate, the GaN-based layers (4) are structured into individual semiconductor layer stacks (5).

14. The method according to claim 13,
wherein
the method continues with the steps of:
- Applying a carrier (6) on to the semiconductor layer stack (5),
- Detaching the composite substrate.

15. The method according to claim 13,
wherein
the method continues with the steps of:
- Applying an intermediate carrier on to the semiconductor layer stack (5),
- Detaching the composite substrate,
- Applying a carrier (6) on to the side of the semiconductor layer stacks (5) that has the composite substrate detached therefrom,
- Detaching the intermediate carrier.

16. The method according to claim 14 or 15,
wherein
the carrier (6) contains at least one of the compounds, respectively at least one of the elements GaAs, germanium, silicon, zinc oxide, molybdenum, aluminum, copper, iron, nickel or cobalt.

17. The method according to claim 16,
wherein
the substrate body contains sapphire and the carrier (6) contains GaAs, molybdenum, tungsten or a Fe-Ni-Co alloy.

18. The method according to claim 16,
wherein
the substrate body (1) contains SiC and the carrier (6) contains silicon or SiC.

19. The method according to one of claims 14 to 18,
wherein
the thermal expansion coefficient of the carrier (6) is between
the thermal expansion coefficient of the substrate body (1) and
the thermal expansion coefficient of the GaN-based layers (4).

20. The method according to one of claims 1 to 19,
wherein
a reflector layer (9) is formed on the GaN-based layers (4) or the semiconductor layer stacks (5), respectively.

21. The method according to claim 20,
wherein
the reflector layer (9) is formed by applying a metal layer.

22. The method according to claim 21,
wherein
the metal layer contains silver, aluminum or a silver alloy or aluminum alloy.

23. The method according to one of claims 20 to 22,
wherein
the reflector layer (9) simultaneously serves as a contact surface.

24. The method according to claim 20,
wherein
the reflector layer (9) is formed by means of a dielectric mirror coating.

25. The method according to one of claims 13 to 24,
wherein
the surface of the semiconductor layer stacks (5) is roughened at least in areas.

26. The method according to claim 25,
wherein
the surface of the semiconductor layer stacks (5) is roughened by means of etching.

27. The method according to claim 25 or 26
wherein
the surface of the semiconductor layer stacks (5) is roughened by means of a sandblasting process.

## Revendications

1. Procédé de fabrication épitaxiale d'un composant semiconducteur présentant une pluralité de couches à base de GaN (4),
dans lequel
les couches à base de GaN (4) sont appliquées sur un substrat composite, lequel comprend un corps de substrat (1) et une couche intermédiaire (2); dans lequel le coefficient de dilatation thermique du corps de substrat (1) s'écarte du coefficient de dilation thermique des couches à base de GaN (4) d'au maximum 50%, ou est supérieur au coefficient de dilatation thermique des couches à base de GaN (4); dans lequel les couches à base de GaN (4) sont déposées par épitaxie sur la couche intermédiaire (2), et dans lequel le corps de substrat (1) présente une épaisseur au moins 20 fois supérieure à celle de la couche intermédiaire (2),
**caractérisé en ce que**
la couche intermédiaire (2) est appliquée sur le corps de substrat (1) au moyen d'un procédé de collage.

2. Procédé selon la revendication 1,
dans lequel
le corps de substrat (1) contient du SiC, poly-SiC, Si, Poly-Si, saphir, GaN, Poly-GaN ou AlN.

3. Procédé selon la revendication 1 ou 2,
dans lequel
la couche intermédiaire (2) contient du SiC, Si, Saphir, MgO, GaN ou AlGaN.

4. Procédé selon l'une quelconque des revendications 1 à 3,
dans lequel
la couche intermédiaire (2) comprend une surface monocristalline au moins dans des sous-régions.

5. Procédé selon l'une quelconque des revendications 1 à 4,
dans lequel
le corps de substrat (1) contient du poly-SiC et la couche intermédiaire (2) contient du SiC monocristallin.

6. Procédé selon l'une quelconque des revendications 1 à 4,
dans lequel
le corps de substrat (1) contient du poly-Si et la couche intermédiaire (2) contient du Si monocristallin.

7. Procédé selon l'une quelconque des revendications 1 à 4,
dans lequel
le corps de substrat (1) contient du poly-GaN et la couche intermédiaire (2) contient du GaN monocristallin.

8. Procédé selon l'une quelconque des revendications 1 à 7,
dans lequel
les couches à base de GaN (4) sont déposées sur une surface en Si (111) ou une surface en SiC de la couche intermédiaire (2) qui est monocristalline au moins dans des sous-régions.

9. Procédé selon l'une quelconque des revendications 1 à 8,
dans lequel
la couche intermédiaire (2) est appliquée sur le corps de substrat (1) au moyen d'un processus de collage oxydique ou d'un processus de collage de tranche.

10. Procédé selon l'une quelconque des revendications 1 à 9,
dans lequel
une couche adhésive (3) est formée entre le corps de substrat (1) et la couche intermédiaire (2).

11. Procédé selon la revendication 10,
dans lequel
la couche adhésive (3) contient de l'oxyde de silicium.

12. Procédé selon l'une quelconque des revendications 1 à 11,
dans lequel
préalablement à l'application des couches à base de GaN (4) sur le substrat composite, une couche de masque (7) présentant des fenêtres d'épitaxie est formée sur le substrat composite, dans lequel la surface d'épitaxie du substrat composite demeure non couverte dans les limites de la fenêtres d'épitaxie.

13. Procédé selon l'une quelconque des revendications 1 à 12,
dans lequel
après application sur le substrat composite, les couches à base de GaN (4) sont structurées en empilements de couches semi-conductrices individuelles (5).

14. Procédé selon la revendication 13,
dans lequel
le procédé se poursuit avec les étapes pour :
- appliquer un support (6) sur l'empilement de couches semi-conductrices (5), et
- séparer le substrat composite.

15. Procédé selon la revendication 13,
dans lequel
le procédé se poursuit avec les étapes pour :
- appliquer un support intermédiaire sur l'empilement de couches semi-conductrices (5);
- séparer le substrat composite, et
- appliquer un support (6) sur le côté des empilements de couches semi-conductrices (5) présentant le substrat composite séparé de celui-ci, et
- séparer le support intermédiaire.

16. Procédé selon la revendication 14 ou 15,
dans lequel
le support (6) contient au moins un des composés, respectivement au moins un des éléments parmi GaAs, germanium, silicium, oxyde de zinc, molybdène, aluminium, cuivre, fer, nickel ou cobalt.

17. Procédé selon la revendication 16,
dans lequel
le corps de substrat contient du saphir et le support (6) contient du GaAs, molybdène, tungstène ou un alliage Fe-Ni-Co.

18. Procédé selon la revendication 16,
dans lequel
le corps de substrat (1) contient du SiC et le support (6) contient du silicium ou du SiC.

19. Procédé selon l'une quelconque des revendications 14 à 18,
dans lequel
le coefficient de dilatation thermique du support (6) s'étend entre le coefficient de dilatation thermique du corps de substrat (1) et le coefficient de dilatation thermique des couches à base de GaN (4).

20. Procédé selon l'une quelconque des revendications 1 à 19,
dans lequel
une couche réflectrice (9) est formée respectivement sur les couches à base de GaN (4) ou les piles de couches semi-conductrices (5).

21. Procédé selon la revendication 20,
dans lequel
la couche réflectrice (9) est formée en appliquant une couche métallique.

22. Procédé selon la revendication 21,
dans lequel
la couche métallique contient de l'argent, de l'aluminium, ou un alliage d'argent ou un alliage d'aluminium.

23. Procédé selon l'une quelconque des revendications 20 à 22,
dans lequel
la couche réflectrice (9) sert simultanément de surface de contact.

24. Procédé selon la revendication 20,
dans lequel
la couche réflectrice (9) est formée au moyen d'un revêtement de miroir diélectrique.

25. Procédé selon l'une quelconque des revendications 13 à 24,
dans lequel
la surface des empilements de couches semi-conductrices (5) est rendue rugueuse au moins dans certaines zones.

26. Procédé selon la revendication 25,
dans lequel
la surface des empilements de couches semi-conductrices (5) est rendue rugueuse par attaque chimique.

27. Procédé selon la revendication 25 ou 26,
dans lequel
la surface des empilements de couches semi-conductrices (5) est rendue rugueuse au moyen d'un procédé de sablage.
